# EUROPÄISCHE PATENTSCHRIFT

(11) **EP 2 736 046 B1**
(45) Veröffentlichungstag und Bekanntmachung des Hinweises auf die Patenterteilung: **11.10.2017**
(21) Anmeldenummer: 13190468.2
(22) Anmeldetag: 28.10.2013
(51) Int. Cl.: G21K 1/10, H01L 41/193, G02B 5/22, G02B 5/20, G02B 26/02

(54) **Adaptiver Strahlenfilter und dessen Verwendung**
Adaptive radiation filter and its use
Filtres à rayons adaptatif et son utilisation

(30) Priorität: 21.11.2012 DE 102012022736
(43) Veröffentlichungstag der Anmeldung: 28.05.2014
(73) Patentinhaber: Fraunhofer-Gesellschaft zur Förderung der angewandten Forschung e.V., 80686 München (DE)
(72) Erfinder: Böse, Holger, 97080 Würzburg (DE); Rabindranath, Raman, 51147 Köln (DE)
(74) Vertreter: Pfenning, Meinig & Partner mbB

(56) Entgegenhaltungen:
- EP-A1- 2 416 111
- JP-A- 2006 126 504

## Beschreibung

Die vorliegende Erfindung betrifft einen adaptiven Strahlenfilter, der mindestens eine Elastomerfolie, die durch Anlegen eines elektrischen Feldes oder eines Magnetfeldes dehnbar ist, aufweist. Mindestens eine Oberfläche der Elastomerfolie ist dabei zumindest bereichsweise mit einer Beschichtung versehen, die einen Strahlenabsorber enthält. Durch die Dehnung der Folie wird dann die Flächenverteilung des mindestens einen Strahlenabsorbers in der Beschichtung verändert. Die Erfindung betrifft weiterhin eine Strahlenblende, die den besagten adaptiven Strahlenfilter enthält. Verwendung findet der adaptive Strahlenfilter als elektrisch oder magnetisch steuerbarer Filter für Röntgenstrahlung, Ultraviolett-Strahlung, Infrarotstrahlung, sichtbares Licht oder Gamma-Strahlung.

Röntgengeräte für medizinische Untersuchungen sollten den Patienten mit einer möglichst geringen Strahlendosis belasten, da mit wachsender Dosis verschiedene Gefahren wie die Auslösung von Krebs oder Veränderungen des Erbguts ansteigen. Durch eine Blende wird gewährleistet, dass der Röntgenstrahl nur auf eine definierte Fläche auftritt. Damit wird die auf den Patienten einwirkende Strahlenbelastung bereits auf einen definierten Körperausschnitt eingeschränkt.

Zur weiteren Reduzierung der Strahlenbelastung wäre es sehr vorteilhaft, wenn die Intensitätsverteilung des Röntgenstrahls durch die Blende flexibel gesteuert werden kann. Hierfür wird ein Filter benötigt, welcher innerhalb des durch die Blende definierten Flächenbereiches die Röntgenstrahlung positionsabhängig unterschiedlich durchlässt. Auf diese Weise wird erreicht, dass die Röntgenstrahlung in höherer Intensität gezielt auf die Stellen auftrifft, an denen es erforderlich ist, während andere Bereiche stärker abgeschattet werden. Mit einem solchen Filter lässt sich die insgesamt eingesetzte Strahlendosis deutlich reduzieren.

Ein bedeutender Fortschritt wäre es, wenn die durch den Filter hindurch gelassene Intensitätsverteilung des Röntgenstrahls den Erfordernissen entsprechend flexibel beeinflusst werden kann.

Bislang sind keine ortsaufgelöst flexibel steuerbaren Filter zur Einstellung der Intensitätsverteilung des Röntgenstrahls bekannt, obwohl von den Herstellern von Röntgengeräten seit vielen Jahren daran gearbeitet wird. Um die Intensität in bestimmten Bereichen zu reduzieren, werden mitunter Gegenstände mit einer vorgegebenen Form in den Strahlengang gebracht die den Röntgenstrahl in den abgedeckten Flächenbereichen schwächen. Solche strahlabschwächenden Gegenstände erzeugen jedoch nur in grober Näherung die gewünschte Intensitätsverteilung. Zudem muss für jede veränderte Intensitätsverteilung ein anderer Gegenstand im Strahlengang positioniert werden.

Ausgehend hiervon war es Aufgabe der vorliegenden Erfindung einen adaptiven Strahlenfilter bereitzustellen, dessen Durchlässigkeit ortsaufgelöst von außen gesteuert wird.

Diese Aufgabe wird durch den adaptiven Strahlenfilter mit den Merkmalen des Anspruchs 1 und die Strahlenblende mit den Merkmalen des Anspruchs 13 gelöst. In Anspruch 15 werden erfindungsgemäße Verwendungen angegeben. Die weiteren abhängigen Ansprüche zeigen vorteilhafte Weiterbildungen auf.

Erfindungsgemäß wird ein adaptiver Strahlenfilter bereit gestellt, der mindestens eine Elastomerfolie aufweist, die durch Anlegen eines elektrischen Feldes oder eines Magnetfeldes dehnbar ist. Mindestens eine Oberfläche der Elastomerfolie ist dabei zumindest bereichsweise mit einer Beschichtung versehen, die mindestens einen Strahlenabsorber enthält. Durch die Dehnung der Elastomerfolie ist dabei die Flächenverteilung des mindestens einen Strahlenabsorbers in der Beschichtung veränderbar.

Die strahlenabsorbierende Beschichtung enthält vorzugsweise strahlenabsorbierende Substanzen oder Partikel aus der folgenden Grupppe:
- röntgenabsorbierende Substanzen oder Partikel aus schweren Elementen, insbesondere Blei, Wolfram, Tantal, Kupfer, Zink oder Eisen,
- UV-absorbierende Substanzen oder Partikel, insbesondere anorganische Substanzen wie Titanoxid, Eisenoxide, Zinkoxid oder anorganischen Substanzen wie Benzophenone, Benzotriazole, Oxalanilide, Phenyltriazine oderTetremethylpiperidin-Derivate,
- IR-absorbierende Substanzen oder Partikel, insbesondere Cobaltphthalocyanin, Lanthanhexaborid oder Anthraquinone,
- Wellenlängenselektiv oder über den gesamten Wellenlängenbereich absorbierende Substanzen oder Partikel für sichtbares Licht, insbesondere organische Farbstoffe wie Anthrachinone, Azofarbstoffe; anorganische Pigmente wie Titandioxid, Ruß, Bismutpigmente, Oxide und Hydroxide, Eisencyanblau, Ultramarin, Cadmiumpigmente und Chromatpigmente,
- Blei, Wolfram, Tantal, Kupfer, Zink, Eisen oder Bariumsulfat und
- Kombinationen hiervon.

Eine bevorzugte Ausführungsform sieht vor, dass die Elastomerfolie eine Dicke 1 µm bis 1 mm, bevorzugt 10 µm bis 500 µm, besonders bevorzugt 100 µm bis 250 µm aufweist.

Die Dicke der strahlenabsorbierenden Beschichtung und/oder die Konzentration der strahlenabsorbierenden Partikel oder Substanzen kann dabei über die Fläche variiert werden.

Die Elastomerfolien enthalten vorzugsweise Silicon, Fluorsilicon, Polyurethan (PUR), Polynorbornen, Naturkautschuk (NR), Styrol-Butadien (SBR), Isobutylen-Isopren (IIR), Ethylen-Propylen-Dien-Terpolymer (EPDM/EPM), Poly-Chlorbutadien (CR), Chlorsulfoniertes Polyethylen (CSM), Acrylnitril-Butadien (NBR), Hydriertes Acrylnitril-Butadien (HNBR), einen Fluorkautschik wie Viton, ein thermoplastisches Elastomer wie thermoplastische Styrol-Copolymere (Styrol-Butadien-Styrol- (SBS-), Styrol-Ethylen-Butadien-Styrol-(SEBS-), Styrol-Ethylen-Propylen-Styrol- (SEPS-), Styrol-Ethylen-Ethylen-Propylen-Styrol- (SEEPS-) oder Styrol-Isopren-Styrol-(SIS-) Copolymer), teilvernetzte Blends auf Polyolefin-Basis (aus Ethylen-Propylen-Dien-Kautschuk und Polypropylen (EPDM/PP), aus Nitril-Butadien-Kautschuk und Polypropylen (NBR/PP) oder aus Ethylen-Propylen-Dien-Kautschuk und Polyethylen(EPDM/PE)) oder thermoplastische Urethan-Copolymere (aromatisches Hartsegment und Ester-Weichsegment (TPU-ARES), aromatisches Hartsegment und Ether-Weichsegment (TPU-ARET) oder aromatisches Hartsegment und Ester/Ether- Weichsegment (TPU-AREE)) oder bestehen hieraus.

Der adaptive Strahlenfilter weist vorzugweise mindestens einen Sensor zur Erfassung des aktuellen Dehnungszustands der strahlenabsorbierenden Beschichtung auf. Hierbei wird vorzugweise ein dielektrischer Elastomersensor eingesetzt, dessen Kapazität gemessen wird.

Eine bevorzugte Ausführungsform sieht vor, dass die Intensitätsverteilung der durchgehenden Strahlung detektiert und damit der adaptive Strahlenfilter steuerbar ist.

Eine erfindungsgemäße Ausführungsform betrifft einen adaptiven Strahlenfilter, der mindestens eine dielektrische Elastomerfolie enthält. Eine solche dielektrische Folie ist auch als dielektrischer Elastomeraktor (DEA) bekannt.

Die dielektrische Elastomerfolie besteht bevorzugt aus einer dehnbaren Elastomerfolie, die beidseitig mit ebenfalls dehnbaren Elektroden beschichtet ist. Die Elektroden behalten auch bei hoher Dehnung eine ausreichende elektrische Leitfähigkeit bei. Beim Anlegen einer elektrischen Spannung zwischen den beiden Elektroden komprimiert sich die Elastomerfolie in der Dicke, während sie sich in der Fläche ausdehnt. Die elektrisch leitfähigen Beschichtungen weisen vorzugsweise eine Dicke von 0,1 µm bis 100 um, bevorzugt 0,5 µm bis 50 µm, besonders bevorzugt 1 bis 25 µm auf.

Vorzugweise kann die erfindungsgemäße Elastomerfolie mit der strahlenabsorbierenden Beschichtung mechanisch ein- oder zweidimensional parallel zur Fläche vorgedehnt sein, wobei die mechanische Vordehnung in einer Dimension von bevorzugt mindestens 50 %, besonders bevorzugt mindestens 100 % vorliegt.

In einer besonderen Ausführungsform enthält die mindestens eine dielektrische Elastomerfolie elektrisch polarisierbare Partikel wie Bariumtitanat, Bleizirkonattitanat oder Titandioxid und/oder elektrisch leitfähige Partikel aus Kohlenstoff wie Ruß, Graphit, Graphen oder Carbon Nanotubes, Metalle wie Eisen, Kupfer, Silber oder Gold oder leitfähige Polymere wie Polyanilin, Polyacetylen, Polypyrrol, Polyparaphenylen oder Polythiophen oder eine organische Modifizierung zur Erhöhung der Permittivität. Die Konzentration dieser Partikel liegt unterhalb der Perkolationsgrenze.

Die elektrisch leitfähigen Beschichtungen enthalten vorzugweise leitfähige Partikel aus Kohlenstoff wie Graphit, Graphen oder Carbon Nanotubes, Metalle wie Eisen, Kupfer, Silber oder Gold oder leitfähige Polymere wie Polyanilin, Polyacetylen, Polypyrrol, Polyparaphenylen oder Polythiophen. Die Konzentration dieser Partikel liegt oberhalb der Perkolationsgrenze.

Die elektrisch leitfähigen Beschichtungen können in einer weiteren Ausführungsform gleichzeitig als strahlenabsorbierende Beschichtung fungieren. In diesem Fall kann auf eine gesonderte Beschichtung verzichtet werden.

Eine DEA-Folie kann ein- oder zweidimensional mechanisch vorgedehnt werden. Außerdem ist es möglich, nur einen Teil der Folienfläche mit Elektroden zu belegen. In diesem Fall dehnt sich der elektrodierte Teil in der Fläche aus, während sich der nicht elektrodierte Teil der Folienfläche durch die mechanische Vorsdehnung zusammenzieht.

Zur Realisierung eines adaptiven Strahlenfilters wird eine teilweise elektrodierte und mechanisch vorgedehnte DEA-Folie teilweise mit einer strahlenabsorbierenden Schicht beschichtet. Die strahlenabsorbierende Beschichtung kann sich zumindest teilweise auf den elektrodierten Flächensegmenten oder zumindest teilweise auf den nicht elektrodierten Flächensegmenten der dielektrischen Elastomerfolie befinden. Handelt es sich bei der Strahlung um Röntgenstrahlen, so besteht die strahlenabsorbierenden Schicht beispielsweise aus Partikeln mit Atomen hoher Ordnungszahl wie Blei, Wolfram, Tantal, Kupfer, Zink oder Eisen, die in einer Elastomerschicht gebunden sind. Diese partikelhaltige Elastomerschicht ist mit der DEA-Folie mechanisch verbunden und wird durch die Dehnung der elektrodierten DEA-Folienfläche ebenfalls mechanisch verformt. Durch diese Verformung ändert sich die Verteilung der strahlenabsorbierenden Partikel auf der Fläche und damit die Durchlässigkeit für den Röntgenstrahl. Durch die angelegte elektrische Spannung an die Elektroden der DEA-Folie kann somit die Filterwirkung elektrisch gesteuert werden. Um eine vollständige Durchlässigkeit des Filters für die Strahlung zu ermöglichen, sollte sich die mechanisch vorgespannte DEA-Folie deutlich über die Fläche der Strahlenblende hinaus erstrecken. Wenn sich die elektrodierten Flächenbereiche und die strahlenabsorbierende Beschichtung anfangs außerhalb der Blende befinden, dann können sich diese durch die Ausdehnung der elektrodierten Flächenbereiche in den Blendenausschnitt hineinverschieben und damit die Strahlung an diesen Stellen absorbieren. Abhängig von der Art und der Konzentration der strahlenabsorbierenden Partikel sowie der Schichtdicke erfolgt eine stärkere oder schwächere Absorption der Strahlung.

Eine einzige derartige mit einer strahlenabsorbierenden Beschichtung versehene DEA-Folie kann die Filterwirkung in vorgegebenen Grenzen verändern, da sich die strahlenabsorbierende Beschichtung innerhalb des Aktuationsbereiches der DEA-Folie verschieben kann. Damit lassen sich bereits grobe Veränderungen des Intensitätsprofils der durchgelassenen Strahlung erzeugen. Wenn jedoch eine feinere Abstufung des Intensitätsprofils gewünscht wird, kann dies durch die Überlagerung mehrerer unabhängig steuerbarer DEA-Folien erreicht werden.

Durch die Überlagerung verschiedener übereinander angeordneter DEA-Folien mit unterschiedlichen Flächensegmenten der Elektroden und der strahlenabsorbierenden Beschichtung können auch steuerbare Filter realisiert werden, bei denen die Intensitätsverteilung in mehr Details variiert werden kann. Dies ist besonders dann möglich, wenn eine einzelne DEA-Folie verschiedene separat elektrisch ansteuerbare Elektrodensegmente aufweist. Dabei sollten sich die einzelnen beschichteten DEA-Folien vorzugsweise nicht berühren und ebenso separat ansteuerbar sein. Mit wachsender Anzahl solcher separat ansteuerbarer beschichteter DEA-Folien lassen sich zunehmend komplexere Filterwirkungen erreichen.

Weitergehende Möglichkeiten bei der Steuerung der Intensitätsverteilung der Strahlung ergeben sich dadurch, dass in der strahlenabsorbierenden Beschichtung entweder die Konzentration der strahlenabsorbierenden Partikel oder die Dicke der Beschichtung variiert. Damit lassen sich beispielsweise weichere Übergänge zwischen nicht bzw. schwach absorbierenden Flächenbereichen und stark bzw. vollständig absorbierenden Bereichen erzielen.

Zur Einstellung der gewünschten Filterwirkung ist es wichtig, dass immer der aktuelle Dehnungszustand der DEA-Folie und besonders der strahlenabsorbierenden Beschichtung erfasst wird. Mit dieser Information kann ggf. die elektrische Spannung zur Aktuation nachgeregelt werden. Eine solche Dehnungsmessung kann sehr vorteilhaft auch über eine dielektrische Elastomerfolie durchgeführt werden, da sich deren elektrische Kapazität bei der Dehnung in definierter Weise verändert. Unter Umständen kann sogar die DEA-Folie selbst für die Dehnungssensorik verwendet werden.

Die Aktorkraft zur Verformung der strahlenabsorbierenden Beschichtung kann auf verschiedene Weisen gesteigert werden. Eine Möglichkeit besteht in der Erhöhung der Dicke der Elastomerfolie zwischen den beiden Elektroden. Dies führt jedoch bei gleichbleibender elektrischer Feldstärke zu einer Erhöhung der Ansteuerspannung. Eine andere Möglichkeit liegt in der Verwendung eines Mehrschichtaufbaus anstatt einer einzelnen DEA-Folie. Hierbei besteht die Aktorfolie aus alternierenden Elastomer- und Dielektrikumsschichten. Auf einer Außenseite ist die strahlenabsorbierende Beschichtung aufgebracht. Eine solche Steigerung der Aktorkraft ist notwendig, wenn die strahlenabsorbierende Beschichtung einen zu hohen mechanischen Widerstand bei der Verformung aufweist.

Um eine elektrische Isolation zu gewährleisten, werden die äußeren Elektroden der dehnbaren Elastomerfolie vorzugsweise mit mindestens einer ebenfalls stark dehnbaren und elektrisch nichtleitfähigen Schutzschicht beschichtet.

Gemäß einer weiteren erfindungsgemäßen Ausführungsform kann die Elastomerfolie auch durch Anlegen eines Magnetfeldes dehnbar sein. Hierzu zählen insbesondere Folien oder Matten aus magnetoreologischen Elastomeren (MRE). MRE sind Elastomerkomposite, die Partikel aus einem magntisierbaren Material wie z. B. Eisen enthalten. Beim Anlegen eines vorzugsweise inhomogenen Magnetfeldes werden die Eisenpartikel durch magnetische Kräfte verschoben und dehnen damit das Elastomer. Durch Aufbringen einer strahlenabsorbierenden Beschichtung auf die MRE-Folie kann die strahlenabsorbierende Beschichtung auch in diesem Fall in ihrer Flächenbedeckung verändert werden. Damit lässt sich ebenfalls die Intensitätsverteilung, z.B. eines Röntgenstrahls, beeinflussen und steuern, wobei dies an dieser Stelle durch ein Magnetfeld anstatt eines elektrischen Feldes erfolgt.

Erfindungsgemäß wird ebenso eine Strahlenblende bereitgestellt, die den zuvor beschriebenen adaptiven Strahlenfilter enthält. Hierbei lässt sich die den mindestens einen Strahlenabsorber enthaltende, dehnbare Beschichtung durch die Aktuation in den Projektionsbereich einer Strahlenblende hineinbewegen oder sich aus dem Projektionsbereich der Strahlenblende herausbewegen.

Vorzugsweise liegen die elektrisch leitfähigen Beschichtungen zumindest teilweise außerhalb des Projektionsbereiches der Strahlenblende oder zumindest teilweise innerhalb des Projektionsbereiches der Strahlenblende.

Erfindungsgemäß lassen sich die adaptiven Strahlenfilter als elektrisch steuerbare Filter für Röntgenstrahlung, Ultraviolett-Strahlung, Infrarotstrahlung, sichtbares Licht oder Gamma-Strahlung einsetzen. Mögliche Anwendungen sind hierbei:
- Einsatz von adaptivem Röntgenfilter in medizinischen Röntgengeräten, um die Strahlenbelastung von Patienten zu reduzieren. Dies ist besonders bedeutsam bei der Computertomographie (CT) mit langen Messzeiten und ständig wechselnden Projektionen
- Einsatz von adaptivem Röntgenfilter in technischen Röntgengeräten zur Materialprüfung, um die Qualität der Aufnahmen zu erhöhen
- Adaptiver UV-Filter zur gezielten Belichtung von Proben mit UV-Licht
- Adaptiver Infrarot-Filter
- Adaptiver und wellenlängenselektiver oder den gesamten Wellenlängenbereich abdeckender Filter für sichtbares Licht
- Adaptiver Filter für Gamma-Strahlen

Anhand der nachfolgenden Figuren soll der erfindungsgemäße Gegenstand näher erläutert werden ohne diesen auf die hier gezeigten spezifischen Ausführungsformen einschränken zu wollen.

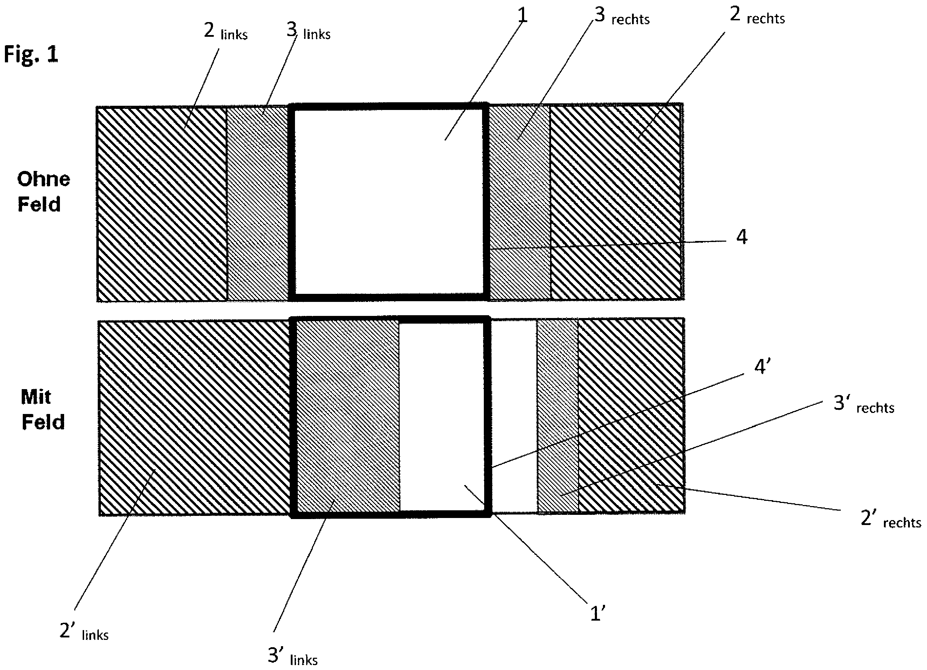

Figur 1 zeigt den Aufbau eines adaptiven Strahlenfilters aus einer mechanisch horizontal vorgedehnten DEA-Folie 1 mit zwei Elektrodensegmenten 2ₗᵢₙₖₛ, 2_{rechts} und röntgenabsorbierenden Beschichtungen 3ₗᵢₙₖₛ, 3_{rechts} jeweils auf den inneren Bereichen der Elektrodensegmente 2ₗᵢₙₖₛ, 2_{rechts} sowie eine rechteckige Blende 4 für den Röntgenstrahl. Die DEA-Folie 1 befindet sich im Grundzustand ohne elektrische Spannung. Figur 1b zeigt die DEA-Folie 1' im verformten Zustand nach Anlegen einer hohen Spannung am linken Elektrodenbereich 2'links, die den linken Elektrodenbereich 2'links und die sich darauf befindliche röntgenabsorbierender Beschichtung 3'links stark nach rechts ausdehnt. Ein analoges Ausführungsbeispiel ergibt sich durch eine vertikale Ausrichtung des adaptiven Strahlenfilters.

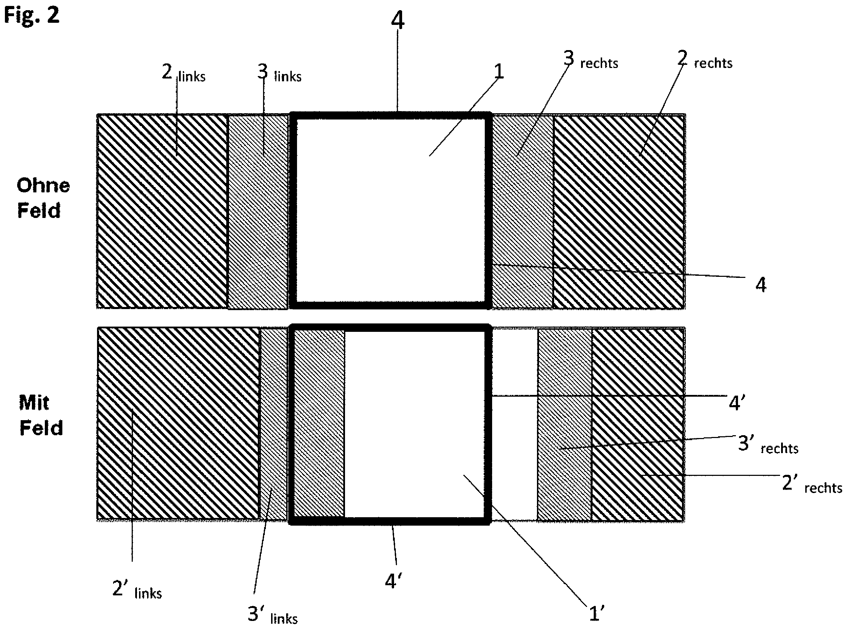

Figur 2 zeigt den Aufbau eines adaptiven Strahlenfilters aus einer mechanisch horizontal vorgedehnten DEA-Folie 1 mit zwei Elektrodensegmenten 2ₗᵢₙₖₛ, 2_{rechts} und röntgenabsorbierenden Beschichtungen 3ₗᵢₙₖₛ, 3_{rechts} jeweils auf den inneren Bereichen der Elektrodensegmente 2ₗᵢₙₖₛ, 2_{rechts} sowie eine rechteckige Blende 4 für den Röntgenstrahl. Die DEA-Folie 1 befindet sich im Grundzustand ohne elektrische Spannung. Figur 2b zeigt die DEA-Folie 1' im verformten Zustand nach Anlegen einer geringeren Spannung als in Figur 1b am linken Elektrodenbereich 2'links, die den linken Elektrodenbereich 2'ₗᵢₙₖₛ und die sich darauf befindliche röntgenabsorbierender Beschichtung 3'links weniger stark als in Figur 1b nach rechts ausdehnt. Ein analoges Ausführungsbeispiel ergibt sich durch eine vertikale Ausrichtung des adaptiven Strahlenfilters.

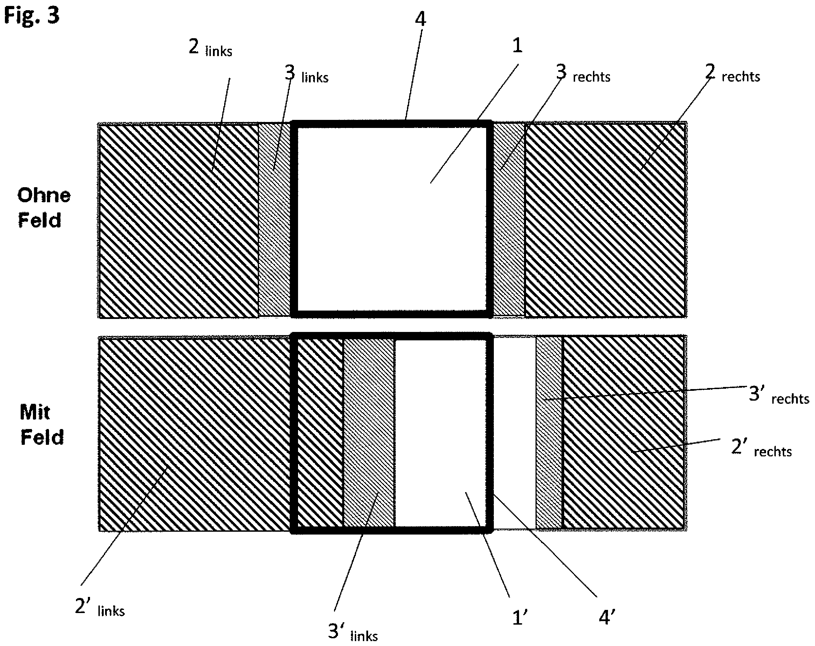

Figur 3 zeigt den Aufbau eines adaptiven Strahlenfilters aus einer mechanisch horizontal vorgedehnten DEA-Folie 1 mit zwei Elektrodensegmenten 2ₗᵢₙₖₛ, 2_{rechts} und röntgenabsorbierenden Beschichtungen 3ₗᵢₙₖₛ, 3_{rechts} jeweils auf kleineren inneren Bereichen der Elektrodensegmente 2ₗᵢₙₖₛ, 2_{rechts} als in Figur 1a sowie eine rechteckige Blende 4 für den Röntgenstrahl. Die DEA-Folie 1 befindet sich im Grundzustand ohne elektrische Spannung. Figur 3b zeigt die DEA-Folie 1' im verformten Zustand nach Anlegen einer hohen Spannung am linken Elektrodenbereich 2'links, die den linken Elektrodenbereich 2'links und die sich darauf befindliche röntgenabsorbierender Beschichtung 3'ₗᵢₙₖₛ stark nach rechts ausdehnt. Ein analoges Ausführungsbeispiel ergibt sich durch eine vertikale Ausrichtung des adaptiven Strahlenfilters.

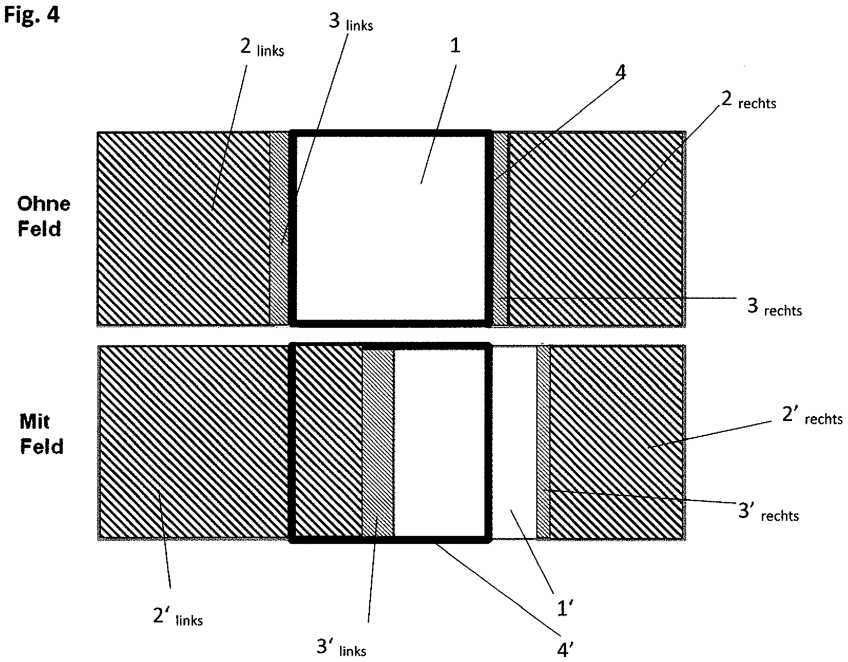

Figur 4 zeigt den Aufbau eines adaptiven Strahlenfilters aus einer mechanisch horizontal vorgedehnten DEA-Folie 1 mit zwei Elektrodensegmenten 2ₗᵢₙₖₛ, 2_{rechts} und röntgenabsorbierenden Beschichtungen 3ₗᵢₙₖₛ, 3_{rechts} jeweils auf noch kleineren inneren Bereichen der Elektrodensegmente 2ₗᵢₙₖₛ, 2_{rechts} als in Figur 3a sowie eine rechteckige Blende 4 für den Röntgenstrahl. Die DEA-Folie 1 befindet sich im Grundzustand ohne elektrische Spannung. Figur 4b zeigt die DEA-Folie 1' im verformten Zustand nach Anlegen einer hohen Spannung am linken Elektrodenbereich 2'links, die den linken Elektrodenbereich 2'links und die sich darauf befindliche röntgenabsorbierender Beschichtung 3'links stark nach rechts ausdehnt. Ein analoges Ausführungsbeispiel ergibt sich durch eine vertikale Ausrichtung des adaptiven Strahlenfilters.

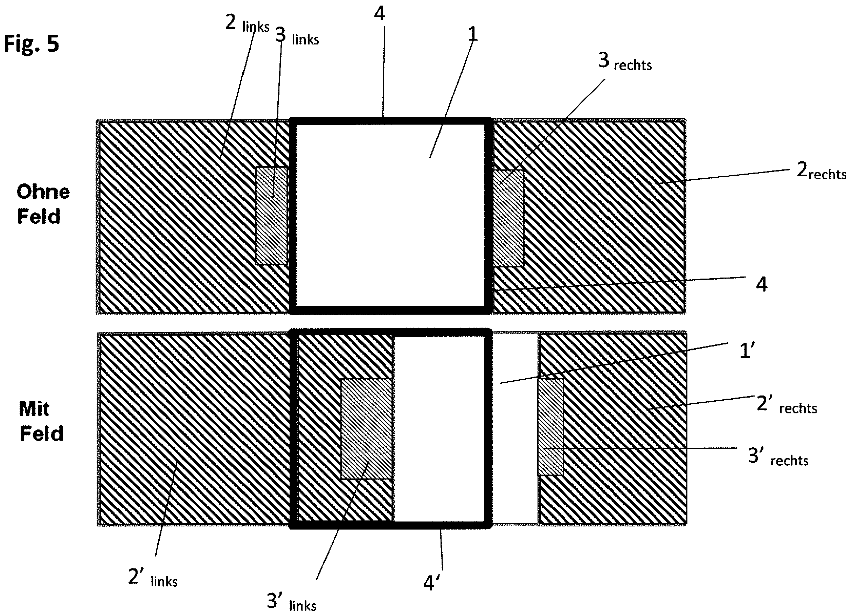

Figur 5 zeigt den Aufbau eines adaptiven Strahlenfilters aus einer mechanisch horizontal vorgedehnten DEA-Folie 1 mit zwei Elektrodensegmenten 2ₗᵢₙₖₛ, 2_{rechts} und röntgenabsorbierenden Beschichtungen 3ₗᵢₙₖₛ, 3_{rechts} jeweils auf den inneren Bereichen der Elektrodensegmente 2ₗᵢₙₖₛ, 2_{rechts} sowie eine rechteckige Blende 4 für den Röntgenstrahl. Der Bereich der röntgenabsorbierenden Beschichtung 3ₗᵢₙₖₛ, 3_{rechts} ist hier in vertikaler Richtung auf die Mitte eingeschränkt. Die DEA-Folie 1 befindet sich im Grundzustand ohne elektrische Spannung. Figur 5b zeigt die DEA-Folie 1' im verformten Zustand nach Anlegen einer hohen Spannung am linken Elektrodenbereich 2'links, die den linken Elektrodenbereich 2'links und die sich darauf befindliche röntgenabsorbierender Beschichtung 3'links stark nach rechts ausdehnt. Ein analoges Ausführungsbeispiel ergibt sich durch eine vertikale Ausrichtung des adaptiven Strahlenfilters.

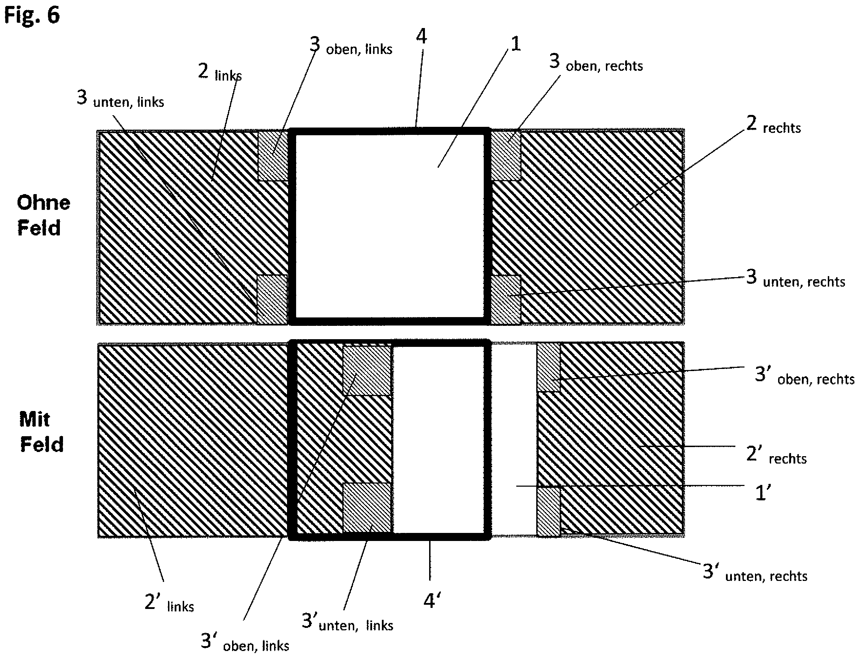

Figur 6 zeigt den Aufbau eines adaptiven Strahlenfilters aus einer mechanisch horizontal vorgedehnten DEA-Folie 1 mit zwei Elektrodensegmenten 2ₗᵢₙₖₛ, 2_{rechts} und röntgenabsorbierenden Beschichtungen 3_{oben,links}, 3_{unten,links}, 3_{oben,rechts}, 3_{unten,rechts} jeweils auf den inneren Bereichen der Elektrodensegmente 2ₗᵢₙₖₛ, 2_{rechts} sowie eine rechteckige Blende 4 für den Röntgenstrahl. Der Bereich der röntgenabsorbierenden Beschichtung 3_{oben,links}, 3_{unten,links}, 3_{oben,rechts}, 3_{unten,rechts} ist hier in vertikaler Richtung auf die Ränder eingeschränkt. Die DEA-Folie 1 befindet sich im Grundzustand ohne elektrische Spannung. Figur 6b zeigt die DEA-Folie 1' im verformten Zustand nach Anlegen einer hohen Spannung am linken Elektrodenbereich 2'links, die den linken Elektrodenbereich 2'links und die sich darauf befindliche röntgenabsorbierender Beschichtung 3_{oben,links}, 3_{unten,links} stark nach rechts ausdehnt. Ein analoges Ausführungsbeispiel ergibt sich durch eine vertikale Ausrichtung des adaptiven Strahlenfilters.

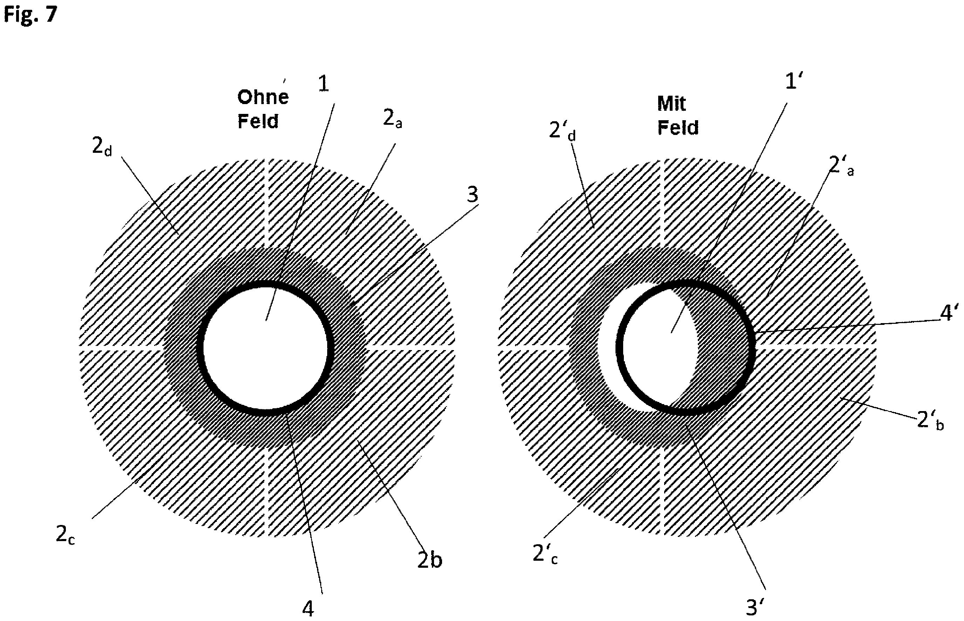

Figur 7 zeigt den Aufbau eines kreisförmigen adaptiven Strahlenfilters aus einer mechanisch horizontal und vertikal vorgedehnten DEA-Folie 1 mit vier Elektrodensegmenten 2ₐ, 2_{b}, 2_{c}, 2_{d} und eine röntgenabsorbierende Beschichtung 3 jeweils auf den inneren Bereichen der Elektrodensegmente sowie eine kreisförmige Blende 4 für den Röntgenstrahl. Die DEA-Folie befindet sich im Grundzustand ohne elektrische Spannung. Figur 7b zeigt die DEA-Folie 1' im verformten Zustand nach Anlegen einer Spannung an den beiden rechten Elektrodensegmenten 2'ₐ, 2'_{b}, die die beiden rechten Elektrodensegmente 2'ₐ, 2'_{b} und die sich darauf befindliche röntgenabsorbierende Beschichtung 3' nach links ausdehnt.

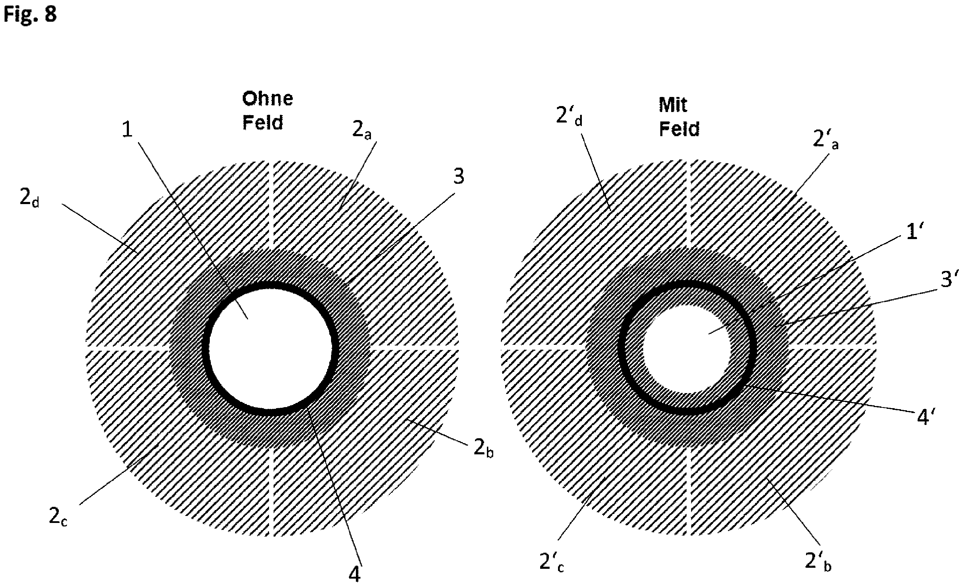

Figur 8 zeigt den Aufbau eines kreisförmigen adaptiven Strahlenfilters aus einer mechanisch horizontal und vertikal vorgedehnten DEA-Folie 1 mit vier Elektrodensegmenten 2ₐ, 2_{b}, 2_{c}, 2_{d} und eine röntgenabsorbierende Beschichtung 3 jeweils auf den inneren Bereichen der Elektrodensegmente sowie eine kreisförmige Blende 4 für den Röntgenstrahl. Die DEA-Folie 1 befindet sich im Grundzustand ohne elektrische Spannung. Figur 8b zeigt die DEA-Folie 1' im verformten Zustand nach Anlegen einer Spannung an allen vier Elektrodensegmenten 2ₐ, 2_{b}, 2_{c}, 2_{d}, die die Elektrodensegmente und die sich darauf befindliche röntgenabsorbierende Beschichtung 3' nach innen ausdehnt.

## Patentansprüche

1. Adaptiver Strahlenfilter enthaltend mindestens eine Elastomerfolie, die durch Anlegen eines elektrischen Feldes oder eines Magnetfeldes dehnbar ist, wobei mindestens eine Oberfläche der Elastomerfolie zumindest bereichsweise eine mindestens einen Strahlenabsorber enthaltende, dehnbare Beschichtung aufweist, wodurch bei Dehnung die Flächenverteilung des mindestens einen Strahlenabsorbers in der Beschichtung veränderbar ist.

2. Adaptiver Strahlenfilter nach Anspruch 1, **dadurch gekennzeichnet, dass** die strahlenabsorbierende Beschichtung Substanzen oder Partikel aus der folgenden Gruppe aufweist:
- UV-absorbierende Substanzen oder Partikel,
- IR-absorbierende Substanzen oder Partikel,
- Wellenlängenselektiv oder über den gesamten Wellenlängenbereich absorbierende Substanzen oder Partikel für sichtbares Licht,
- Blei, Wolfram, Tantal, Kupfer, Zink, Eisen oder Bariumsulfat und
- Kombinationen hiervon.

3. Adaptiver Strahlenfilter nach einem der vorangehenden Ansprüche, **dadurch gekennzeichnet, dass** die Elastomerfolie eine Dicke 1 µm bis 1 mm, bevorzugt 10 µm bis 500 µm, besonders bevorzugt 100 µm bis 250 µm aufweist.

4. Adaptiver Strahlenfilter nach einem der vorangehenden Ansprüche, **dadurch gekennzeichnet, dass** die Dicke der strahlenabsorbierende Beschichtung und/oder die Konzentration der strahlenabsorbierenden Partikel oder Substanzen über die Fläche variiert.

5. Adaptiver Strahlenfilter nach einem der vorangehenden Ansprüche, **dadurch gekennzeichnet, dass** die Elastomerfolien Silicon, Fluorsilicon, Polyurethan (PUR), Polynorbornen, Naturkautschuk (NR), Styrol-Butadien (SBR), Isobutylen-Isopren (IIR), Ethylen-Propylen-Dien-Terpolymer (EPDM/EPM), Poly-Chlorbutadien (CR), Chlorsulfoniertes Polyethylen (CSM), Acrylnitril-Butadien (NBR), Hydriertes Acrylnitril-Butadien (HNBR), einen Fluorkautschik wie Viton, ein thermoplastisches Elastomer wie thermoplastische Styrol-Copolymere (Styrol-Butadien-Styrol- (SBS-), Styrol-Ethylen-Butadien-Styrol- (SEBS-), Styrol-Ethylen-Propylen-Styrol- (SEPS-), Styrol-Ethylen-Ethylen-Propylen-Styrol- (SEEPS-) oder Styrol-Isopren-Styrol-(SIS-) Copolymer), teilvernetzte Blends auf Polyolefin-Basis (aus Ethylen-Propylen-Dien-Kautschuk und Polypropylen (EPDM/PP), aus Nitril-Butadien-Kautschuk und Polypropylen (NBR/PP) oder aus Ethylen-Propylen-Dien-Kautschuk und Polyethylen(EPDM/PE)) oder thermoplastische Urethan-Copolymere (aromatisches Hartsegment und Ester-Weichsegment (TPU-ARES), aromatisches Hartsegment und Ether-Weichsegment (TPU-ARET) oder aromatisches Hartsegment und Ester/Ether- Weichsegment (TPU-AREE)) enthält oder daraus besteht.

6. Adaptiver Strahlenfilter nach einem der vorhergehenden Ansprüche, **dadurch gekennzeichnet, dass** die mindestens eine Elastomerfolie auf beiden Seiten bereichsweise jeweils mindestens eine dehnbare elektrisch leitfähige Beschichtung als Elektroden aufweist, wobei die dehnbare elektrisch leitfähige Beschichtung vorzugsweise eine Dicke von 0,1 µm bis 100 µm, bevorzugt 0,5 µm bis 50 µm, besonders bevorzugt 1 µm bis 25 µm aufweisen.

7. Adaptiver Strahlenfilter nach Anspruch 6, **dadurch gekennzeichnet, dass** die elektrisch leitfähigen Beschichtungen leitfähige Partikel aus Kohlenstoff wie Ruß, Graphit, Graphen oder Carbon Nanotubes, Metalle wie Eisen, Kupfer, Silber oder Gold oder leitfähige Polymere wie Polyanilin, Polyacetylen, Polypyrrol, Polyparaphenylen oder Polythiophen enthalten.

8. Adaptiver Strahlenfilter nach einem der vorhergehenden Ansprüche, **dadurch gekennzeichnet, dass** mindestens eine Elastomerfolie magnetisierbare Partikel aufweist.

9. Adaptiver Strahlenfilter nach einem der vorangehenden Ansprüche, **dadurch gekennzeichnet, dass** die Elastomerfolie mit der strahlenabsorbierenden Beschichtung mechanisch ein- oder zweidimensional parallel zur Fläche vorgedehnt ist und die mechanische Vordehnung in einer Dimension mindestens 50 %, besonders bevorzugt mindestens 100 % beträgt.

10. Adaptiver Strahlenfilter nach einem der vorangehenden Ansprüche, **dadurch gekennzeichnet, dass** mindestens zwei Elastomerfolien mit strahlenabsorbierenden Beschichtungen übereinander angeordnet sind und separat ansteuerbar sind.

11. Adaptiver Strahlenfilter nach einem der vorangehenden Ansprüche, **dadurch gekennzeichnet, dass** der adaptive Strahlenfilter mindestens einen Sensor zur Erfassung des aktuellen Dehnungszustands der strahlenabsorbierenden Beschichtung aufweist, insbesondere ein dielektrischer Elastomersensor, dessen Kapazität messbar ist.

12. Adaptiver Strahlenfilter nach einem der vorangehenden Ansprüche, **dadurch gekennzeichnet, dass** die Intensitätsverteilung der durchgehenden Strahlung detektiert wird und damit der adaptive Strahlenfilter steuerbar ist.

13. Strahlenblende enthaltend einen adaptiver Strahlenfilter nach einem der vorangehenden Ansprüche, wobei sich die den mindestens einen Strahlenabsorber enthaltende, dehnbare Beschichtung durch die Aktuation in den Projektionsbereich einer Strahlenblende hineinbewegen oder sich aus dem Projektionsbereich der Strahlenblende herausbewegen läßt.

14. Strahlenblende nach Anspruch 13, **dadurch gekennzeichnet, dass** die elektrisch leitfähigen Beschichtungen und/oder die mindestens eine strahlenabsorbierende Beschichtung zumindest teilweise außerhalb des Projektionsbereiches der Strahlenblende oder zumindest teilweise innerhalb des Projektionsbereiches der Strahlenblende liegen.

15. Verwendung des adaptiven Strahlenfilters nach einem der Ansprüche 1 bis 12 als elektrisch oder magnetisch steuerbarer Filter für Röntgenstrahlung, Ultraviolett-Strahlung, Infrarot-Strahlung, sichtbares Licht oder Gamma-Strahlung.

## Claims

1. Adaptive radiation filter comprising at least one elastomeric foil which is stretchable by applying an electric field or a magnetic field, wherein at least one surface of the elastomeric foil has at least in regions a stretchable coating comprising at least one radiation absorber, whereby the areal distribution of the at least one radiation absorber in the coating is variable during stretching.

2. Adaptive radiation filter according to claim 1, **characterized in that** the radiation-absorbent coating comprises substances or particles from the following group:
- UV-absorbent substances or particles,
- IR-absorbent substances or particles,
- Wavelength-selective or in the whole wavelength range absorbent substances or particles for visible light,
- lead, tungsten, tantalum, copper, zinc, iron or barium sulphate and
- combinations thereof.

3. Adaptive radiation filter according to one of the preceding claims, **characterized in that** the elastomeric foil has a thickness from 1 µm to 1 mm, preferably from 10 µm to 500 µm, particularly preferred from 100 µm to 250 µm.

4. Adaptive radiation filter according to one of the preceding claims, **characterized in that** the thickness of the radiation-absorbent coating and/or the concentration of the radiation-absorbent particles or substances varies over the area.

5. Adaptive radiation filter according to one of the preceding claims, **characterized in that** the elastomeric foils comprise or consist of silicon, fluorosilicon, polyurethane (PUR), polynorbornene, natural rubber (NR), styrene-butadiene (SBR), isobutylene-isoprene (IIR), ethylene-propylene-diene-terpolymer (EPDM/EPM), poly-chlorobutadiene (CR), chlorosulfonated polyethylene (CSM), acrylonitrile-butadiene (NBR), hydrated acrylonitrile-butadiene (HNBR), a fluororubber such as Viton, a thermoplastic elastomer such as thermoplastic styrene-copolymers (styrene-butadiene-styrene- (SBS-), styrene-ethylene-butadiene-styrene- (SEBS-), styrene-ethylene-propylene-styrene- (SEPS-), styrene-ethylene-ethylene-propylene-styrene- (SEEPS-) or styrene-isoprene-styrene-(SIS-) copolymer), partly cross-linked blends on polyolefinebasis (made of ethylene-propylene-diene-rubber and polypropylene (EPDM/PP), made of nitrile-butadiene-rubber and polypropylene (NBR/PP) or made of ethylene-propylene-diene-rubber and polyethylene(EPDM/PE)) or thermoplastic urethane copolymers (aromatic rigid segment and ester-soft segment (TPU-ARES), aromatic rigid segment and ether-soft segment (TPU-ARET) or aromatic rigid segment and ester/ether-soft segment (TPU-AREE)).

6. Adaptive radiation filter according to one of the preceding claims, **characterized in that** the at least one elastomeric foil comprises at least one stretchable electrically conductive coating on both sides as electrodes, wherein the stretchable electrically conductive coating has a thickness of 0.1 µm to 100 µm, preferably from 0.5 µm to 25 µm, particularly preferred from 1 µm to 25 µm.

7. Adaptive radiation filter according to claim 6, **characterized in that** the electrically conductive coatings comprise conductive particles made of carbon such as carbon black, graphite, graphene or carbon nanotubes, metals such as iron, copper, silver or gold or conductive polymers such as polyaniline, polyacetylene, polypyrrole, polyparaphenylene or polythiophene.

8. Adaptive radiation filter according to one of the preceding claims, **characterized in that** at least one elastomeric foil comprises magnetizable particles.

9. Adaptive radiation filter according to one of the preceding claims, **characterized in that** the elastomeric foil with the radiation-absorbent coating is pre-stretched mechanically one- or two-dimensionally parallelly to the area and the mechanical pre-stretch is at least 50 % in one dimension, particularly preferred at least 100 %.

10. Adaptive radiation filter according to one of the preceding claims, **characterized in that** at least two elastomeric foils with radiation-absorbent coatings are arranged on top of each other and are separately controllable.

11. Adaptive radiation filter according to one of the preceding claims, **characterized in that** the adaptive radiation filter comprises at least one sensor for recording the current stretch condition of the radiation-absorbent coating, particularly a dielectric elastomeric sensor, the capacity of which is measurable.

12. Adaptive radiation filter according to one of the preceding claims, **characterized in that** the intensity distribution of the passing radiation is detected and the adaptive radiation filter is controllable therewith.

13. Radiation blend comprising an adaptive radiation filter according to one of the preceding claims, wherein the stretchable coating comprising the at least one radiation absorber can move into the projection area of a radiation blend or move out of the projection area of the radiation blend by the actuation.

14. Radiation blend according to claim 13, **characterized in that** the electrically conductive coatings and/or the at least one radiation-absorbent coating are located at least partly outside the projection area of the radiation blend or at least partly inside the projection area of the radiation blend.

15. Use of an adaptive radiation filter according to one of the claims 1 to 12 as electrically or magnetically controllable filter for X-radiation, UV-radiation, IR-radiation, visible light or gamma radiation.

## Revendications

1. Filtre adaptatif de rayonnement, contenant au moins une feuille élastomère, qui peut s'étendre par application d'un champ électrique ou d'un champ magnétique, au moins une surface de la feuille élastomère présentant, au moins par zones, un revêtement extensible, contenant au moins un absorbeur de rayonnement, la répartition en surface de l'au moins un absorbeur de rayonnement dans le revêtement pouvant être modifiée sous l'effet de l'extension.

2. Filtre adaptatif de rayonnement selon la revendication 1, **caractérisé en ce que** le revêtement absorbant le rayonnement comprend des substances ou des particules du groupe suivant :
- les substances ou particules absorbant les UV,
- les substances ou particules absorbant les IR,
- les substances ou particules à absorption sélective de longueur d'onde ou sur la totalité de la gamme de longueurs d'onde, pour la lumière visible,
- du plomb, du tungstène, du tantale, du cuivre, du zinc, du fer ou du sulfate de baryum, et
- les combinaisons de ceux-ci.

3. Filtre adaptatif de rayonnement selon l'une des revendications précédentes, **caractérisé en ce que** la feuille élastomère présente une épaisseur de 1 µm à 1 mm, de préférence de 10 µm à 500 µm, d'une manière particulièrement préférée de 100 µm à 250 µm.

4. Filtre adaptatif de rayonnement selon l'une des revendications précédentes, **caractérisé en ce que** l'épaisseur du revêtement absorbant le rayonnement et/ou la concentration des particules ou des substances absorbant le rayonnement, varie sur la surface.

5. Filtre adaptatif de rayonnement selon l'une des revendications précédentes, **caractérisé en ce que** les feuilles élastomères contiennent de la silicone, de la fluorosilicone, du polyuréthanne (PUR), du polynorbornène, du caoutchouc naturel (NR), du styrène-butadiène (SBR), de l'isobutylène-isoprène (IIR), un terpolymère éthylène-propylène-diène (EPDM/EPM), du poly-chlorobutadiène (CR), du polyéthylène chlorosulfoné (CSM), de l'acrylonitrile-butadiène (NBR), de l'acrylonitrile-butadiène hydrogéné (HNBR), un caoutchouc fluoré tel que le Viton, un élastomère thermoplastique tel que des copolymères du styrène thermoplastiques (copolymère styrène-butadiène-styrène (SBS), styrène-éthylène-butadiène-styrène (SEBS), styrène-éthylène-propylène-styrène (SEPS), styrène-éthylène-éthylène-propylène-styrène (SEEPS) ou styrène-isoprène-styrène (SIS)), des mélanges partiellement réticulés à base d'une polyoléfine (de caoutchouc éthylène-propylène-diène et de polypropylène (EPDM/PP), de caoutchouc nitrilebutadiène et de polypropylène (NBR/PP) ou de caoutchouc éthylène-propylène-diène et de polyéthylène (EPDM/PE)), ou des copolymères de l'uréthanne thermoplastiques (segment dur aromatique et segment mou ester (TPU-ARES), segment dur aromatique et segment mou éther (TPU-ARET) ou segment dur aromatique et segment mou ester/éther (TPU-AREE)), ou en sont constituées.

6. Filtre adaptatif de rayonnement selon l'une des revendications précédentes, **caractérisé en ce que** l'au moins une feuille élastomère présente sur chacune de ses deux faces, par zones, au moins un revêtement extensible conducteur de l'électricité en tant qu'électrodes, le revêtement extensible conducteur de l'électricité présentant de préférence une épaisseur de 0,1 µm à 100 µm, de préférence de 0,5 µm à 50 µm, d'une manière particulièrement préférée de 1 µm à 25 µm.

7. Filtre adaptatif de rayonnement selon la revendication 6, **caractérisé en ce que** les revêtements conducteurs de l'électricité contiennent des particules de carbone conductrices de l'électricité, telles que le noir de carbone, le graphite, le graphène ou les nanotubes de carbone, des métaux tels que le fer, le cuivre, l'argent ou l'or, ou des polymères conducteurs tels qu'une polyaniline, un polyacétylène, un polypyrrole, un polyparaphénylène ou un polythiophène.

8. Filtre adaptatif de rayonnement selon l'une des revendications précédentes, **caractérisé en ce qu'**au moins une feuille élastomère comprend des particules aimantables.

9. Filtre adaptatif de rayonnement selon l'une des revendications précédentes, **caractérisé en ce que** la feuille élastomère, comprenant le revêtement absorbant le rayonnement, est soumise à une pré-extension mécanique mono- ou bidimensionnelle parallèlement à la surface, et que la pré-extension mécanique est, dans une dimension, d'au moins 50 %, d'une manière particulièrement préférée d'au moins 100 %.

10. Filtre adaptatif de rayonnement selon l'une des revendications précédentes, **caractérisé en ce qu'**au moins deux feuilles élastomères, comportant des revêtements absorbant le rayonnement, sont disposées l'une au-dessus de l'autre et peuvent être excitées séparément.

11. Filtre adaptatif de rayonnement selon l'une des revendications précédentes, **caractérisé en ce que** le filtre adaptatif de rayonnement présente au moins un capteur pour déterminer l'état effectif d'extension du revêtement absorbant le rayonnement, en particulier un capteur élastomère diélectrique dont la capacité est mesurable.

12. Filtre adaptatif de rayonnement selon l'une des revendications précédentes, **caractérisé en ce qu'**on détecte la répartition de l'intensité du rayonnement traversant, ce grâce à quoi le filtre adaptatif de rayonnement peut être commandé.

13. Diaphragme de rayonnement contenant un filtre adaptatif de rayonnement selon l'une des revendications précédentes, dans lequel le revêtement extensible, contenant l'au moins un absorbeur de rayonnement, peut sous l'effet de l'actionnement être introduit dans la zone de projection d'un diaphragme de rayonnement ou expulsé de la zone de projection du diaphragme de rayonnement.

14. Diaphragme de rayonnement selon la revendication 13, **caractérisé en ce que** les revêtements conducteurs de l'électricité et/ou l'au moins un revêtement absorbant le rayonnement se trouvent au moins partiellement à l'extérieur de la zone de projection du diaphragme de rayonnement ou au moins partiellement à l'intérieur de la zone de projection du diaphragme de rayonnement.

15. Utilisation du filtre adaptatif de rayonnement selon l'une des revendications 1 à 12 en tant que filtre à commande électrique ou magnétique pour le rayonnement X, le rayonnement ultraviolet, le rayonnement infrarouge, la lumière visible ou le rayonnement gamma.
